# EUROPÄISCHE PATENTSCHRIFT

(11) **EP 4 331 918 B1**
(45) Veröffentlichungstag und Bekanntmachung des Hinweises auf die Patenterteilung: **05.08.2026**
(21) Anmeldenummer: 23179450.4
(22) Anmeldetag: 15.06.2023
(51) Int. Cl.: B60R 16/023, H05K 5/00

(54) **ANORDNUNG ZUM BEFESTIGEN EINES STEUERGERÄTS AN EINER KAROSSERIE EINER LANDWIRTSCHAFTLICHEN ARBEITSMASCHINE**
ARRANGEMENT FOR FIXING A CONTROL DEVICE TO A BODY OF AN AGRICULTURAL MACHINE
AGENCEMENT DE FIXATION D'UN APPAREIL DE COMMANDE SUR UNE CARROSSERIE D'UNE MACHINE DE TRAVAIL AGRICOLE

(30) Priorität: 29.08.2022 DE 102022121765
(43) Veröffentlichungstag der Anmeldung: 06.03.2024
(73) Patentinhaber: CLAAS Tractor S.A.S., 78141 Vélizy-Villacoublay Cedex (FR)
(72) Erfinder: Benallal, Mohamed, 92330 Sceaux (FR); Valin, Damien, 78560 Le Port Marly (FR)
(74) Vertreter: CLAAS Gruppe

(56) Entgegenhaltungen:
- CN-B- 110 816 438
- DE-U1- 212015 000 078
- US-A1- 2020 047 694
- US-B1- 9 771 030

## Beschreibung

Die vorliegende Anmeldung betrifft eine Anordnung zum Befestigen eines Steuergeräts an einer Karosserie einer landwirtschaftlichen Arbeitsmaschine, insbesondere eines Traktors, gemäß dem Oberbegriff des unabhängigen Patentanspruchs 1 sowie eine landwirtschaftliche Arbeitsmaschine, insbesondere einen Traktor, mit einem Steuergerät und einer solchen Anordnung zum Befestigen eines Steuergeräts an einer Karosserie einer landwirtschaftlichen Arbeitsmaschine gemäß dem Patentanspruch 13.

Landwirtschaftliche Arbeitsmaschinen umfassen ein oder mehrere Steuergeräte, die während einer Durchführung eines Arbeitsauftrags verschiedene für die Durchführung des Arbeitsauftrags erforderliche Daten derart verarbeiten, dass die Arbeitsaggregate der landwirtschaftlichen Arbeitsmaschine entsprechend angesteuert werden können. Derartige Steuergeräte - auch als "electronic control units" (ECU) bezeichnet - sind während des Betriebs von landwirtschaftlichen Arbeitsmaschinen erheblichen Belastungen ausgesetzt. Bei der Durchführung von landwirtschaftlichen Arbeitsaufträgen auf einer landwirtschaftlichen Fläche mit einer unebenen Bodenoberfläche oder auf einer Hofstätte ist die landwirtschaftliche Arbeitsmaschine erheblichen Kräften ausgesetzt, die dafür sorgen, dass die Steuergeräte Stöße erfahren, die für eine Relativbewegungen von Steuergerät zu landwirtschaftlicher Arbeitsmaschine sorgen können.

Um solche Relativbewegungen zwischen den Steuergeräten und der landwirtschaftlichen Arbeitsmaschine zu unterbinden, ist es vorgesehen, die Steuergeräte an der landwirtschaftlichen Arbeitsmaschine zu befestigen. In aller Regel werden die Steuergeräte mit Karosserieelementen der landwirtschaftlichen Arbeitsmaschine verschraubt oder verankert, um solche Bewegungen zu vermeiden. Eine Herausforderung, die mit der Befestigung der Steuergeräte an Karosserieelementen einhergeht, ist die, dass diese Art und Weise der Befestigung aufgrund der Bewegungen des Fahrzeugs zu übermäßig starken Vibrationen der Steuergeräte führen kann. Insbesondere dann, wenn die Steuergeräte an einer oder in der Nähe einer Vibrationen bzw. Schwingungen verursachenden Komponente der landwirtschaftlichen Arbeitsmaschine, beispielsweise einem Antriebsmotor, angeordnet bzw. befestigt sind, müssen die Steuergeräte so befestigt sein, dass sie sich einerseits nicht lösen andererseits aber auch den auftretenden Vibrationen standhalten können. Insbesondere bei Steuergeräten gilt es zu beachten, dass diese besonders empfindlich gegenüber auftretenden Vibrationen sind, so dass hier eine Anbringung nötig ist, die das Steuergerät zumindest weitgehend von den Vibrationen bzw. Schwingungen entkoppelt.

Daher wird für die Anbringung von Steuergeräten oftmals ein mehrteiliges Befestigungssystem mit schwingungsdämpfenden bzw. -reduzierenden Elementen verwendet, um das Steuergerät zumindest weitgehend von den auftretenden Vibrationen bzw. Schwingungen während des Betriebs der landwirtschaftlichen Arbeitsmaschine zu entkoppeln und auch den Einfluss von durch den Betrieb der landwirtschaftlichen Arbeitsmaschine während der Durchführung von Arbeitsaufträgen verursachten Stößen auf die Steuergeräte entgegenzuwirken.

Aus der US 9,771,030 B1 ist beispielsweise ein solches mehrteilige Befestigungssystem zur Befestigung eines Steuergeräts, insbesondere eines Motorsteuergeräts, an einem Fahrzeug bekannt. Das Befestigungssystem umfasst ein erstes Befestigungselement, ein zweites Befestigungselement und ein drittes Befestigungselement, das mit dem ersten Befestigungselement und dem zweiten Befestigungselement durch eine Vielzahl von ersten Isolierelementen und durch eine Vielzahl von ersten Befestigungsmitteln verbunden ist. Das dritte Befestigungselement umfasst einen Basisabschnitt mit einem ersten und einem zweiten Ende. Der Basisabschnitt ist durch mindestens ein zweites Isolierelement und durch mindestens ein zweites Befestigungsmittel mit dem Steuergerät verbunden. Das dritte Befestigungselement umfasst einen ersten Schenkel, der mit dem ersten Befestigungselement verbunden ist. Das dritte Befestigungselement umfasst ferner einen zweiten Schenkel, der mit dem zweiten Befestigungselement verbunden ist.

Nachteilig bei solchen bekannten mehrteiligen Befestigungssystemen für Steuergeräte an einem Fahrzeug ist, dass diese eine erhebliche Zahl an Einzelteilen umfassen, die alle einzeln über eine Vielzahl an Befestigungsmitteln miteinander befestigt werden müssen. Durch die Anordnung der verschiedenen Befestigungselemente in verschiedenen Ebenen ist es für einen Monteur äußerst aufwendig ein derartiges Befestigungssystem zu montieren oder für Wartungszwecke zu demontieren, da die Befestigungsmittel in verschiedenen Ebenen liegen. Auch ist die Zugänglichkeit zum Steuergerät durch die mehrteilige Ausgestaltung des Befestigungssystems oder durch das Befestigungssystem umgebene Strukturen des Fahrzeugs nur bedingt gegeben, so dass sich die Montage des Steuergeräts, insbesondere aber die Demontage bei Wartungsarbeiten, als sehr arbeitsaufwändig und komplex erweisen kann. Insbesondere bei landwirtschaftlichen Arbeitsmaschinen kann die Zugänglichkeit aufgrund einer anderen Fahrzeugarchitektur und dem Vorhandensein von spezifischen Arbeitsaggregaten noch weiter eingeschränkt sein.

Weitere Befestigungssysteme sind aus der US 2020/047694 A1, CN 110 816 438 B und der DE 21 2015 000078 U1 bekannt.

Ausgehend hiervon ist es demnach die Aufgabe der vorliegenden Erfindung, eine Anordnung zum Befestigen eines Steuergeräts an einer Karosserie einer landwirtschaftlichen Arbeitsmaschine, insbesondere eines Traktors, anzugeben, die eine gute Zugänglichkeit zum Steuergerät sowie eine unkomplizierte Montage und Demontage des Steuergeräts an der Karosserie der landwirtschaftlichen Arbeitsmaschine erlaubt, gleichzeitig eine hinreichende Entkopplung des Steuergeräts von auftretenden Vibrationen und Schwingungen während des Betriebs der landwirtschaftlichen Arbeitsmaschine erzielt.

Diese Aufgabe wird erfindungsgemäß durch die Merkmale des unabhängigen Patentanspruchs 1 gelöst, wobei vorteilhafte Weiterbildungen der erfindungsgemäßen Anordnung Gegenstand der entsprechenden abhängigen Patentansprüche 2 bis 12 sind.

Demnach betrifft die vorliegende Erfindung eine Anordnung zum Befestigen eines Steuergeräts an einer Karosserie einer landwirtschaftlichen Arbeitsmaschine, insbesondere eines Traktors. Die Anordnung umfasst ein Halteelement, welches an der Karosserie der landwirtschaftlichen Arbeitsmaschine befestigbar oder befestigt ist, und ein Trägerelement, an dem das Steuergerät anordenbar oder angeordnet ist. Die Anordnung ist dadurch gekennzeichnet, dass das Halteelement mindestens einen Befestigungssteg umfasst. Das Trägerelement umfasst mindestens ein erstes Pufferelement und mindestens ein zweites Pufferelement, wobei das erste Pufferelement und das zweite Pufferelement an zwei verschiedenen Seiten des Trägerelements angeordnet ist. Zum Befestigen des Trägerelements an dem Halteelement ist das erste Pufferelement mit dem Befestigungssteg und das zweite Pufferelement mittels eines Befestigungsmittels mit dem Halteelement verbindbar oder verbunden.

Die Befestigung des Trägerelements mit dem Halteelement über einen Befestigungssteg und die Verwendung eines Befestigungsmittels erlaubt es, dass zum Montieren und Demontieren der Anordnung bzw. des Steuergeräts an bzw. von der Karosserie der landwirtschaftlichen Arbeitsmaschine lediglich von einer Seite eine Zugänglichkeit zur Anordnung gegeben sein muss. Durch ein Festziehen bzw. Lösen des Befestigungsmittels kann das Trägerelement mit oder von dem Halteelement auf unkomplizierte Art und Weise befestigt oder entfernt werden. Durch die Verwendung eines an dem Halteelement angeordneten Befestigungsstegs kann mittels nur eines Befestigungsmittels eine sichere Befestigung des Steuergeräts an der Karosserie der landwirtschaftlichen Arbeitsmaschine erfolgen. Dadurch, dass die Pufferelemente bei der Befestigung des Trägerelements an dem Halteelement mitwirken, wird zusätzlich eine Entkopplung des Steuergeräts von etwaigen durch Stöße bei der Bewegung der landwirtschaftlichen Arbeitsmaschine oder durch den Betrieb von Arbeitsaggregaten induzierten Vibrationen bzw. Schwingungen sichergestellt. Gleichzeitig wird die Anzahl an Einzelteilen im Vergleich zu herkömmlichen Befestigungssystemen reduziert, da lediglich zwei tragende Elemente, das Halteelement und das Trägerelement, über Pufferelemente und eine Kombination eines Befestigungsstegs und eines Befestigungsmittels miteinander zum Befestigen des Steuergeräts an der Karosserie der landwirtschaftlichen Arbeitsmaschine benötigt werden.

Die Anordnung ist insbesondere zum Befestigen eines Motorsteuergeräts an einem der Halterung einer Motorhaube der landwirtschaftlichen Arbeitsmaschine dienenden Karosserieelement der landwirtschaftlichen Arbeitsmaschine geeignet.

Insbesondere bei der Befestigung eines Motorsteuergeräts an dem der Halterung der Motorhaube der landwirtschaftlichen Arbeitsmaschine dienenden Karosserieelement ist die erfindungsgemäße Anordnung als besonders vorteilhaft anzusehen, da hier einerseits aufgrund von Kabeln, Schläuchen und diversen dem Antriebsmotor zugeordneten Nebenaggregaten nur eine sehr begrenzte Zugänglichkeit gegeben ist und andererseits durch den Betrieb des Antriebsmotors die Gefahr von erheblichen Vibrationen bzw. Schwingungen besteht.

Gemäß einer vorteilhaften Weiterbildung der Erfindung ist vorgesehen, dass das Trägerelement U-förmig ausgebildet ist. Das Trägerelement umfasst eine erste Wange und eine zweite Wange, die mittels eines Verbindungsstegs miteinander verbunden sind. Das erste Pufferelement ist an der ersten Wange und das zweite Pufferelement ist an der zweiten Wange angeordnet.

Die U-förmige Ausgestaltung des Trägerelements mit zwei Wangen und einem die Wangen miteinander verbindenden Verbindungssteg sorgt für eine besonders bauraumsparende Ausgestaltung der Anordnung, die gleichzeitig eine Anbindungsmöglichkeit für das Steuergerät schafft und eine Integration der Pufferelemente zur Reduzierung bzw. Tilgung von Vibrationen bzw. Schwingungen erlaubt.

Vorzugsweise umfasst die erste Wange mindestens eine Ausnehmung, insbesondere Bohrung, in der das erste Pufferelement angeordnet ist, und die zweite Wange mindestens eine Ausnehmung, insbesondere Bohrung, in der das zweite Pufferelement angeordnet ist.

Durch die in die Wangen eingebrachten Ausnehmungen wird eine besonders einfache Möglichkeit geschaffen, die Pufferelemente an dem Trägerelement anzuordnen bzw. zu befestigen. Durch ein Einstecken der Pufferelemente in die Ausnehmungen können diese derart an dem Trägerelement befestigt werden, dass sie sich nicht ungewollt von diesem lösen. Insbesondere erfolgt die Anordnung der Pufferelemente in den Ausnehmungen derart, dass eine formschlüssige Verbindung zwischen Trägerelement und dem jeweiligen Pufferelement geschaffen wird, wodurch auf zusätzliche Befestigungsmittel und/oder Klebstoffe zum Befestigen der Pufferelemente an dem Trägerelement verzichtet werden kann.

Weiter vorzugsweise sind das erste Pufferelement das zweite Pufferelement jeweils derart in der jeweiligen Ausnehmung der ersten Wange und der zweiten Wange angeordnet, dass eine in dem ersten Pufferelement und eine in dem zweiten Pufferelement ausgebildete Ausnehmung zum Aufnehmen des Befestigungsstegs oder des Befestigungsmittels von dem die erste Wange und die zweite Wange miteinander verbindenden Verbindungssteg weg weist.

Durch diese Anordnung der Pufferelemente wird eine gute Zugänglichkeit zu den Ausnehmungen in den Pufferelementen ermöglicht, wodurch ein Eingriff des Befestigungsstegs bzw. des Befestigungsmittels zum Befestigen des Trägerelements mit dem Halteelement auf besonders unkomplizierte Art und Weise erfolgen kann. Weiterhin wird der zwischen dem ersten und zweiten Pufferelement vorhandene Bauraum nicht für die Befestigung des Trägerelements an dem Halteelement verwendet, so dass dieser für die Anbindung bzw. Befestigung des Steuergeräts genutzt werden kann.

Erfindungsgemäß ist vorgesehen, dass das Halteelement U-förmig ausgebildet ist. Das Halteelement umfasst eine erste Wange und eine zweite Wange, die mittels eines Verbindungsstegs, vorzugsweise zweier Verbindungstege, miteinander verbunden sind. Der Befestigungssteg ist an der ersten Wange ausgebildet und die zweite Wange umfasst mindestens eine Ausnehmung, insbesondere Bohrung, zum Aufnehmen des Befestigungsmittels.

Durch die U-förmige Ausgestaltung des Halteelements mit zwei Wangen und zumindest einem die beiden Wangen miteinander verbindenden Verbindungssteg wird eine zu dem Trägerelement im Wesentlichen komplementäre Ausgestaltung des Halteelements geschaffen. Die komplementäre Ausgestaltung von Halteelement und Trägerelement begünstigt den reduzierten Bauraumbedarf für die Anbringung der Anordnung samt Steuergerät.

Gemäß einer vorteilhaften Weiterbildung der Erfindung ist vorgesehen, dass die erste Wange und die zweite Wange des Trägerelements und/oder die erste Wange und die zweite Wange des Halteelements an einander gegenüberliegenden Seiten des jeweiligen die beiden Wangen miteinander verbindenden Verbindungsstegs angeordnet sind.

Hierdurch werden das Trägerelement und Halteelement dem Prinzip nach bei einer Montage miteinander verspannt, indem das Trägerelement zwischen den Wangen des Halteelements aufgenommen ist, wodurch sichergestellt wird, dass ausreichend Platz für die Anbindung des Steuergeräts an das Trägerelement vorhanden ist und eine Zugänglichkeit zum Steuergerät auch im befestigten Zustand des Steuergeräts an der Karosserie der landwirtschaftlichen Arbeitsmaschine sichergestellt bleibt.

Erfindungsgemäß ist vorgesehen, dass der Befestigungssteg ein Bolzen mit konisch ausgebildetem Bolzenkopf ist. Das erste Pufferelement ist rastend mit dem Befestigungssteg verbindbar oder verbunden.

Während des Festziehens oder Lösens des Befestigungsmittels zum Montieren oder Demontieren des Trägerelements mit dem Halteelement wird durch die rastende Ausgestaltung sichergestellt, dass sich das Trägerelement mit oder ohne Steuergerät nicht sofort gänzlich vom Halteelement löst und dabei herunterfällt. Der Montage- oder Demontageprozess kann somit unkompliziert erfolgen, ohne dass die Gefahr besteht, dass das Steuergerät hierbei versehentlich beschädigt wird.

Gemäß einer vorteilhaften Weiterbildung der Erfindung ist vorgesehen, dass das zweite Pufferelement mit dem Halteelement mittels einer Schraube verbindbar oder verbunden ist.

Gemäß einer vorteilhaften Weiterbildung der Erfindung ist vorgesehen, dass das erste Pufferelement und/oder das zweite Pufferelement schwingungsdämpfend ausgebildet ist.

Hierdurch wird eine Tilgung bzw. Reduzierung von Vibrationen und Schwingungen in besonders hohem Maße erzielt, so dass das an und für sich empfindliche Steuergerät vor etwaigen Beschädigungen und einem vorzeitigen Austausch geschützt wird.

Gemäß einer vorteilhaften Weiterbildung der Erfindung ist vorgesehen, dass das erste Pufferelement und/oder das zweite Pufferelement buchsenförmig ausgebildet ist.

Aus dieser Ausgestaltung folgt, dass der Befestigungssteg bzw. das Befestigungsmittel im Anbindungsbereich vollständig von dem Pufferelement aufgenommen sind, wodurch Schwingungen und Vibrationen des Befestigungsmittels oder den Befestigungssteg an einem Übertritt auf das Trägerelement und somit das Steuergerät zumindest weitgehend gehindert werden.

Gemäß einer vorteilhaften Weiterbildung der Erfindung ist vorgesehen, dass das Trägerelement zwei erste Pufferelement und zwei zweite Pufferelement und das Halteelement zwei Befestigungsstege umfasst. Zum Befestigen des Trägerelements an dem Halteelement ist jeweils ein erstes Pufferelement mit jeweils einem Befestigungssteg und jeweils ein zweites Pufferelement mittels jeweils eines Befestigungsmittels mit dem Halteelement verbindbar oder verbunden.

Hierdurch wird eine besonders stabile Anbindung der Elemente miteinander realisiert. Etwaige Verwindungen von Halteelement und Trägerelement relativ zueinander aufgrund von

Vibrationen, Schwingungen und/oder Stößen können somit ausgeschlossen werden, wodurch ungewollte auf das Steuergerät wirkende Spannungszustände verhindert werden. Gemäß einer vorteilhaften Weiterbildung der Erfindung ist vorgesehen, dass das Halteelement form-, kraft- und/oder stoffschlüssig mit der Karosserie der landwirtschaftlichen Arbeitsmaschine verbindbar oder verbunden ist.

Gemäß einer vorteilhaften Weiterbildung der Erfindung ist vorgesehen, dass das Trägerelement kraft-, form- und/oder stoffschlüssig mit dem Steuergerät befestigbar oder befestigt ist. Alternativ hierzu ist vorgesehen, dass das Trägerelement integral mit dem Steuergerät ausgebildet ist.

Gemäß einer vorteilhaften Weiterbildungserfindung ist vorgesehen, dass das Trägerelement an einer der Befestigung des Steuergeräts dienenden Seite abgewandten Seite Kühlrippen umfasst.

Hierdurch kommt dem Trägerelement neben der Funktion der Befestigung des Steuergeräts noch die Funktion der Wärmeabfuhr zu, die während des Betriebs des Steuergeräts entsteht.

Die erfindungsgemäße Aufgabe wird ferner durch eine landwirtschaftliche Arbeitsmaschine, insbesondere einen Traktor, gemäß dem Patentanspruch 13 gelöst, wobei eine vorteilhafte Weiterbildung der erfindungsgemäßen landwirtschaftliche Arbeitsmaschine Gegenstand des entsprechenden abhängigen Patentanspruchs 14 ist.

Demnach betrifft die vorliegende Erfindung weiterhin eine landwirtschaftliche Arbeitsmaschine, insbesondere einen Traktor, mit einem Steuergerät. Die landwirtschaftliche Arbeitsmaschine ist dadurch gekennzeichnet, dass die landwirtschaftliche Arbeitsmaschine eine zuvor beschriebene Anordnung zum Befestigen eines Steuergeräts an einer Karosserie der landwirtschaftlichen Arbeitsmaschine umfasst mittels der das Steuergerät an der Karosserie der landwirtschaftlichen Arbeitsmaschine befestigt ist.

Vorzugsweise ist vorgesehen, dass das Steuergerät ein Motorsteuergerät ist, das mittels der Anordnung an einem der Halterung einer Motorhaube der landwirtschaftlichen Arbeitsmaschine dienenden Karosserieelement der landwirtschaftlichen Arbeitsmaschine befestigt ist. Die vorliegende Erfindung wird nachstehend anhand der in den Figuren abgebildeten Ausführungsformen näher beschrieben.

Es zeigen:
- FIG. 1: eine schematische und exemplarische Darstellung einer erfindungsgemäßen landwirtschaftlichen Arbeitsmaschine in Gestalt eines Traktors;
- FIG. 2: eine schematische und exemplarische Darstellung eines an einem der Halterung einer Motorhaube einer landwirtschaftlichen Arbeitsmaschine dienenden Karosserieelement befestigten Motorsteuergeräts;
- FIG. 3: eine schematische und exemplarische Darstellung einer erfindungsgemäßen Anordnung zum Befestigen eines Steuergeräts an einer Karosserie der erfindungsgemäßen landwirtschaftlichen Arbeitsmaschine;
- FIG. 4: eine weitere schematische und exemplarische Darstellung der erfindungsgemäßen Anordnung aus FIG. 3 mit voneinander bereichsweise gelöstem Halte- und Trägerelement; und
- FIG. 5: eine schematische und exemplarische Teildarstellung des Halteelements der erfindungsgemäßen Anordnung aus den FIGs. 3 und 4.

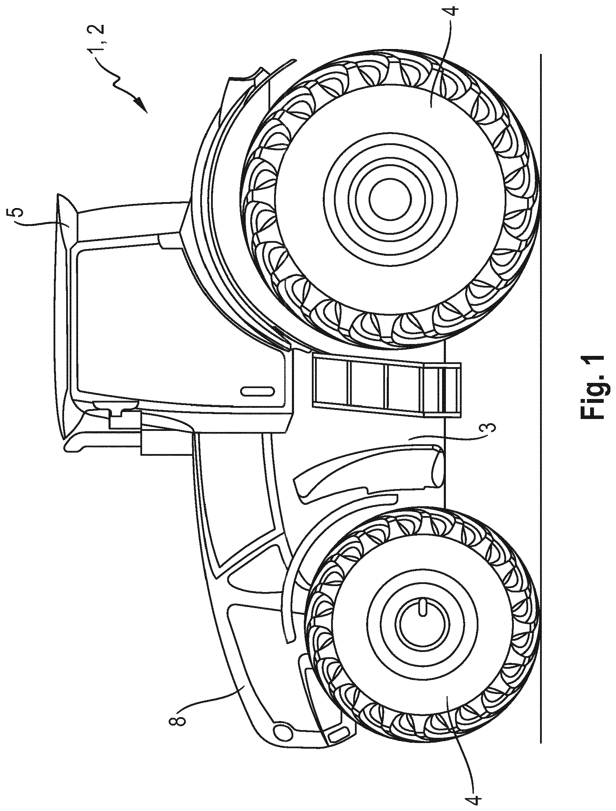

In FIG. 1 ist schematisch und exemplarisch eine landwirtschaftliche Arbeitsmaschine 1 abgebildet. Die landwirtschaftliche Arbeitsmaschine 1 ist in FIG. 1 als Traktor 2 ausgebildet. Die als Traktor 2 ausgebildete landwirtschaftliche Arbeitsmaschine 1 umfasst unter anderem eine Karosserie 3, Bodeneingriffsmittel 4, eine auf der Karosserie 3 gelagerte Kabine 5 sowie - in FIG. 1 nicht dargestellte - Arbeitsaggregate.

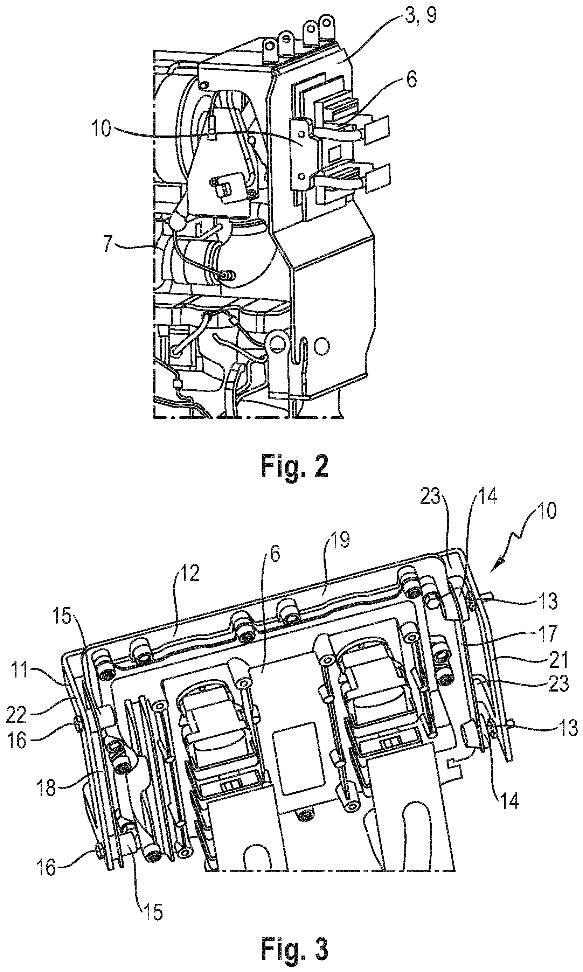

Neben diesen Komponenten umfasst der Traktor 2 weiterhin zumindest ein Steuergerät 6, welches der Verarbeitung von Daten zur Ansteuerung der Arbeitsaggregate des Traktors 2 dient. In FIG. 2 ist ein solches Steuergerät 6 abgebildet, welches an der Karosserie 3 des Traktors 2 befestigt ist. Bei dem in FIG. 2 dargestellten Steuergerät 6 handelt es sich um ein Motorsteuergerät, welches der Ansteuerung eines Antriebsmotors 7 des Traktors 2 dient. Das Motorsteuergerät ist an einem der Halterung einer - in FIG. 1 dargestellten - Motorhaube 8 des Traktors 2 dienenden Karosserieelement 9 befestigt. Zur Befestigung des Motorsteuergeräts an der Karosserie 3 des Traktors 2 ist eine Anordnung 10 vorgesehen, die in FIG. 2 lediglich schematisch angedeutet ist.

Bezugnehmend auf die FIGs. 3 bis 5 wird nachfolgend eine erfindungsgemäße Ausgestaltung einer solchen Anordnung 10 zum Befestigen eines Steuergeräts 6 an der Karosserie 3 einer landwirtschaftlichen Arbeitsmaschine 1, hier und vorzugsweise eines Traktors 2, beschrieben.

Auch wenn die erfindungsgemäße Anordnung 10 im Folgenden im Kontext einer als Traktor 2 ausgebildeten landwirtschaftlichen Arbeitsmaschine 1 beschrieben wird, so kann die Anordnung 10 gleichermaßen im Kontext anderer landwirtschaftliche Arbeitsmaschinen 1, wie beispielsweise eines Mähdreschers oder eines Feldhäckslers Verwendung finden. Entsprechendes gilt auch für die Ausgestaltung des Steuergeräts 6. Auch wenn es sich bei dem in den FIGs. 2 bis 4 dargestellten Steuergerät 6 um ein Motorsteuergerät handelt, ist die Anordnung 10 nicht nur für die Befestigung von Motorsteuergeräten geeignet, sondern gleichermaßen für die Befestigung anderer Steuergeräte einer landwirtschaftlichen Arbeitsmaschine 1 bzw. eines Traktors 2. Der Traktor 2 kann weiterhin nicht nur ein Steuergerät 6 umfassen, sondern eine Vielzahl an Steuergeräten 6, die der Ansteuerung verschiedener Arbeitsaggregate des Traktors 2 dienen, wobei jedes der Vielzahl an Steuergeräten 6 mittels einer erfindungsgemäßen Anordnung 10 an der Karosserie 3 des Traktors 2 befestigbar oder befestigt ist.

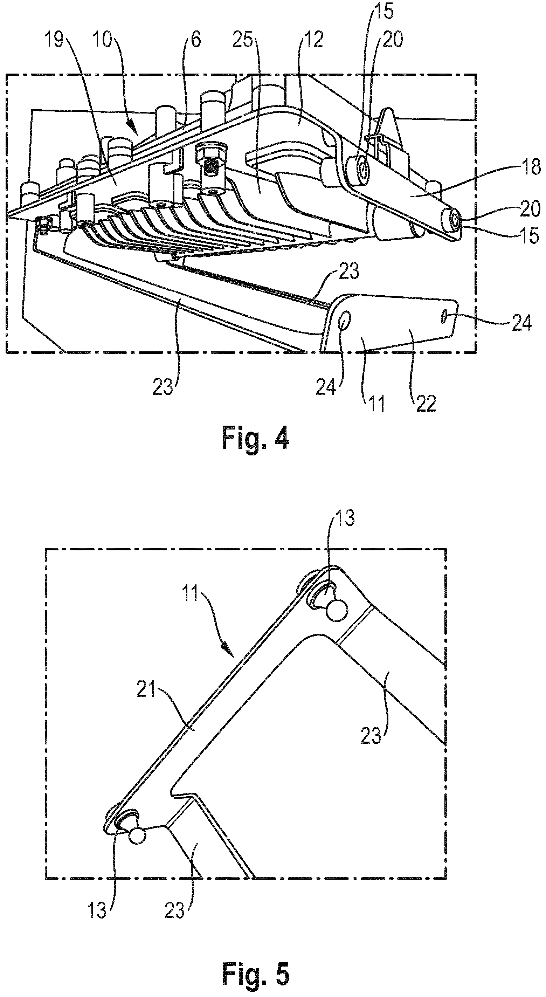

FIG. 3 zeigt eine Ausführungsform der erfindungsgemäßen Anordnung 10. Die Anordnung 10 umfasst ein Halteelement 11, welches an der Karosserie 3 des Traktors 2 befestigbar oder befestigt ist. Die Befestigung des Halteelements 11 an der Karosserie 3 des Traktors 3 kann wahlweise form-, kraft- und/oder stoffschlüssig erfolgen. Vorzugsweise wird das Halteelement 11 an der Karosserie 3 des Traktors 2 verschraubt. Neben dem Halteelement 11 umfasst die Anordnung 10 weiterhin ein Trägerelement 12, an dem das Steuergerät 6 anordenbar oder angeordnet ist. Die Anbindung des Steuergeräts 6 an das Trägerelement 12 kann wahlweise kraft-, form- und/oder stoffschlüssig erfolgen. Vorzugsweise wird das Steuergerät 6 mit dem Trägerelement 12 verschraubt, hier und vorzugsweise, wie in FIG. 4 dargestellt, ist eine Schrauben-Mutter-Kombination zum Befestigen gewählt. Alternativ hierzu ist es auch möglich, dass das Trägerelement 12 eine Komponente des Steuergeräts 6 ausbildet. Mit anderen Worten, sind das Trägerelement 12 und das Steuergerät 6 in einer solchen Ausgestaltung integral ausgebildet. Das Halteelement 11 umfasst zwei Befestigungsstege 13 und das Trägerelement 12 umfasst zwei erste Pufferelemente14 und zwei zweite Pufferelemente 15. Auch wenn in den FIGs. jeweils zwei Befestigungsstege 13 und jeweils zwei erste Pufferelemente 14 und zwei zweite Pufferelemente 15 dargestellt sind, so ist eine Ausgestaltung der erfindungsgemäßen Anordnung 10 mit nur einem Befestigungssteg 13 und mit jeweils nur einem ersten Pufferelement 14 und einem zweiten Pufferelement 15 ebenso möglich.

Die ersten Pufferelemente 14 und die zweiten Pufferelemente 15 sind an zwei verschiedenen Seiten des Trägerelement 12 angeordnet. Bei der in den FIGs. dargestellten Ausgestaltung mit jeweils zwei Befestigungsstegen 13, zwei ersten Pufferelementen 14 und zwei zweiten Pufferelementen 15 ist es vorgesehen, dass die zwei Befestigungsstege 13 an der gleichen Seite des Trägerelements 12 angeordnet sind.

Zum Befestigen des Trägerelement 12 an dem Halteelement 11 ist ein erstes Pufferelement 14 mit einem entsprechenden Befestigungssteg 13 des Halteelements 11 und ein zweites Pufferelement 15 mittels eines Befestigungsmittels 16 unmittelbar mit dem Halteelement 11 verbindbar. In einem montierten Zustand des Halteelement 11 mit dem Trägerelement 12 bzw. in einem montierten Zustand der Anordnung 10 an dem Traktor 2 ist demnach ein erstes Pufferelement 14 mit einem entsprechenden Befestigungssteg 13 des Halteelements 11 und ein zweites Pufferelement 15 mittels eines Befestigungsmittels 16 unmittelbar mit dem Halteelement 11 verbunden.

Das Trägerelement 12 der Anordnung 10 ist U-förmig ausgebildet. Das Trägerelement 12 umfasst eine erste Wange 17 und eine zweite Wange 18, die mittels eines Verbindungsstegs 19 miteinander verbunden sind. Der Verbindungssteg 19 dient der Befestigung bzw. Anbindung des Steuergeräts 6. Die ersten Pufferelemente 14 sind an der ersten Wange 17 und die zweiten Pufferelemente 15 an der zweiten Wange 18 angeordnet. Hierzu umfasst die erste Wange 17 zwei Ausnehmungen, die insbesondere als Bohrungen ausgestaltet sind, wobei in jeweils einer Ausnehmung jeweils ein erstes Pufferelement 14 angeordnet ist. Die zweite Wange 18 umfasst entsprechend zwei Ausnehmungen, die ebenfalls insbesondere als Bohrungen ausgestaltet sind, wobei in jeweils einer Ausnehmung jeweils ein zweites Pufferelement 15 angeordnet ist. Die ersten Pufferelemente 14 und die zweiten Pufferelemente 15 sind dabei derart in ihrer jeweiligen Ausnehmung in einer der Wangen 17, 18 angeordnet, dass eine in jedem ersten Pufferelement 14 und jedem zweiten Pufferelement 15 ausgebildete Ausnehmung 20, die insbesondere in FIG. 4 dargestellt ist, zum Aufnehmen eines Befestigungsstegs 13 oder eines Befestigungsmittels 16 derart ausgerichtet ist, dass diese von dem die erste und zweite Wange 17, 18 des Trägerelements 12 miteinander verbindenden Verbindungssteg 19 weg weist.

Die ersten Pufferelemente 14 und die zweiten Pufferelemente 15 sind vorzugsweise buchsenförmig ausgebildet, so dass wahlweise der Befestigungssteg 13 oder das Befestigungsmittel 16 bei einem Befestigen des Halteelements 11 mit dem Trägerelement 12 in die buchsenförmig ausgebildeten Pufferelemente 14, 15 eingreifen, wodurch sie im Anbindungsbereich vollständig von dem jeweiligen Pufferelement 14, 15 aufgenommen bzw. umgeben sind.

Weiter vorzugsweise sind die ersten und zweiten Pufferelemente 14 ,15 schwingungsdämpfend ausgebildet, so dass auf das Halteelement 11 wirkende Vibration bzw. Schwingungen an einem Übertritt auf das Trägerelement 12 und somit das Steuergerät 6 gehindert werden. Mit anderen Worten, die Pufferelemente 14, 15 reduzieren bzw. tilgen eventuell auftretende Vibrationen bzw. Schwingungen und schützen somit das Steuergerät 6 im Betrieb des Traktors 2. Besonders bevorzugt sind die ersten und zweiten Pufferelemente 14, 15 aus einem elastomeren Kunststoff ausgebildet.

Die Befestigungsstege 13 sind, wie in der isolierten Teildarstellung des Halteelements 11 gemäß FIG. 5 dargestellt, als Bolzen mit konisch ausgebildetem Bolzenkopf ausgestaltet. Die ersten Pufferelemente 14 und die Befestigungsstege 13, die miteinander bei einem Befestigen des Halteelements 11 mit dem Trägerelement 12 in Eingriff gelangen, bilden bei einer derartigen Ausgestaltung des Befestigungsstegs 13 miteinander eine rastende Verbindung aus, die während eines Montage- oder Demontageprozesses der Anordnung 10 eine gewisse Sicherung gegen ein ungewolltes Lösen des Trägerelements 12 von dem Halteelement 11 schafft.

Weiterhin ist es vorzugsweise vorgesehen, dass die Befestigungsmittel 16 jeweils als Schraube ausgebildet sind, so dass das zweite Pufferelement 15 mit dem Halteelement 11 jeweils über eine Schraubverbindung verbindbar bzw. verbunden ist. Andere Ausgestaltungen der Befestigungsmittel 16 sind jedoch gleichermaßen möglich.

Entsprechend zum Trägerelement 12 ist das Halteelement 11 der Anordnung 10 ebenfalls U-förmig ausgebildet, so dass das Trägerelement 12 und das Halteelement 11 zumindest im Wesentlichen komplementär ausgebildet sind. Demnach umfasst auch das Haltelement 11 eine erste Wange 21 und eine zweite Wange 22, die mittels zweier Verbindungsstege 23 miteinander verbunden sind. Anstelle zweier Verbindungsstege 23 ist eine Verbindung der Wangen 21, 22 miteinander über nur einen Verbindungssteg 23 ebenfalls möglich. Die Befestigungsstege 13 sind an der ersten Wange 21 ausgebildet. Die zweite Wange 22 umfasst zwei Ausnehmungen 24, die in FIG. 4 dargestellt, die insbesondere als Bohrungen ausgestaltet sind und der Aufnahme der Befestigungsmittel 16 dienen.

Sowohl bei dem Halteelement 11 als auch bei dem Trägerelement 12 ist es vorgesehen, dass die erste Wange 17, 21 und die zweite Wange 18, 22 aneinander gegenüberliegenden Seiten des die beiden Wangen 17, 18; 21, 22 miteinander verbindenden Verbindungsstegs 19, 23 angeordnet sind.

In einem montierten Zustand des Halteelement 11 an der Karosserie 3 des Traktors 2 weisen sowohl die erste Wange 21 als auch die zweite Wange 22 des Halteelement 11 von der Karosserie 3 des Traktors 2 weg. Das Trägerelement 12 kann hingegen in einem an das Halteelement 11 befestigten Zustand wahlweise derart ausgerichtet sein, dass die erste und zweite Wange 17, 18 des Trägerelements 12 von dem Halteelement 11 weg weisen, wie in FIG. 3 dargestellt, oder aber in Richtung des Halteelements 11 weisen, wie in FIG. 4 dargestellt.

Dem Trägerelement 12 kann, wie der FIG. 4 zu entnehmen ist, optional neben der Befestigungsfunktion für das Steuergerät 6 noch eine weitere Funktion zukommen. Auf einer Seite, die der Seite abgewandt ist, an der das Steuergerät 6 angeordnet ist, können Kühlrippen 25 ausgebildet sein. Die bei einem Betrieb des Steuergeräts 6 auftretende Wärme kann über die Kühlrippen 25 des Trägerelements 12 effizient abgeführt werden.

Abschließend sei angemerkt, dass die vorstehend beschriebenen Ausführungsformen lediglich zur Beschreibung der beanspruchten Lehre dienen, diese jedoch keinesfalls als einschränkend oder erschöpfend anzusehen sind.

### Bezugszeichenliste

- 1: Landwirtschaftliche Arbeitsmaschine
- 2: Traktor
- 3: Karosserie
- 4: Bodeneingriffsmittel
- 5: Kabine
- 6: Steuergerät
- 7: Antriebsmotor
- 8: Motorhaube
- 9: Karosserieelement
- 10: Anordnung zum Befestigen eines Steuergeräts
- 11: Halteelement
- 12: Trägerelement
- 13: Befestigungssteg
- 14: erstes Pufferelement
- 15: zweites Pufferelement
- 16: Befestigungsmittel
- 17: erste Wange des Trägerelements
- 18: zweite Wange des Trägerelements
- 19: Verbindungssteg des Trägerelements
- 20: Ausnehmung im Pufferelement
- 21: erste Wange des Halteelements
- 22: zweite Wange des Halteelements
- 23: Verbindungssteg des Halteelements
- 24: Ausnehmung an der zweiten Wange des Halteelements
- 25: Kühlrippen

## Patentansprüche

1. Anordnung (10) zum Befestigen eines Steuergeräts (6) an einer Karosserie (3) einer landwirtschaftlichen Arbeitsmaschine (1), insbesondere eines Traktors (2), wobei die Anordnung (10) ein Halteelement (11), welches an der Karosserie (3) der landwirtschaftlichen Arbeitsmaschine (1) befestigbar oder befestigt ist, und ein Trägerelement (12), an dem das Steuergerät (6) anordenbar oder angeordnet ist, umfasst, wobei das Halteelement (11) mindestens einen Befestigungssteg (13) umfasst, wobei das Trägerelement (12) mindestens ein erstes Pufferelement (14) und mindestens ein zweites Pufferelement (15) umfasst, wobei das erste Pufferelement (14) und das zweite Pufferelement (15) an zwei verschiedenen Seiten des Trägerelements (12) angeordnet ist, wobei zum Befestigen des Trägerelements (12) an dem Halteelement (11) das erste Pufferelement (14) mit dem Befestigungssteg (13) und das zweite Pufferelement (15) mittels eines Befestigungsmittels (16) mit dem Halteelement (11) verbindbar oder verbunden ist, **dadurch gekennzeichnet, dass** das Halteelement (11) U-förmig ausgebildet ist, wobei das Halteelement (11) eine erste Wange (21) und eine zweite Wange (22) umfasst, die mittels eines Verbindungsstegs (23), vorzugsweise zweier Verbindungsstege (23), miteinander verbunden sind, wobei der Befestigungssteg (13) an der ersten Wange (21) ausgebildet ist, wobei die zweite Wange (22) mindestens eine Ausnehmung (24), insbesondere Bohrung, zum Aufnehmen des Befestigungsmittels (16) umfasst, wobei der Befestigungssteg (13) ein Bolzen mit konisch ausgebildetem Bolzenkopf ist, wobei das erste Pufferelement (14) rastend mit dem Befestigungssteg (13) verbindbar oder verbunden ist.

2. Anordnung (10) nach Anspruch 1, **dadurch gekennzeichnet, dass** das Trägerelement (12) U-förmig ausgebildet ist, wobei das Trägerelement (12) eine erste Wange (17) und eine zweite Wange (18) umfasst, die mittels eines Verbindungsstegs (19) miteinander verbunden sind, wobei das erste Pufferelement (14) an der ersten Wange (17) und das zweite Pufferelement (15) an der zweiten Wange (18) angeordnet ist.

3. Anordnung (10) nach Anspruch 2, **dadurch gekennzeichnet, dass** die erste Wange (17) mindestens eine Ausnehmung, insbesondere Bohrung, in der das erste Pufferelement (14) angeordnet ist, und die zweite Wange (18) mindestens eine Ausnehmung, insbesondere Bohrung, in der das zweite Pufferelement (15) angeordnet ist, umfasst.

4. Anordnung (10) nach Anspruch 3, **dadurch gekennzeichnet, dass** das erste Pufferelement (14) und das zweite Pufferelement (15) jeweils derart in der jeweiligen Ausnehmung der ersten Wange (17) und der zweiten Wange (18) angeordnet ist, dass eine in dem ersten Pufferelement (14) und eine in dem zweiten Pufferelement (15) ausgebildete Ausnehmung (20) zum Aufnehmen des Befestigungsstegs (13) oder des Befestigungsmittels (16) von dem die erste Wange (17) und die zweite Wange (18) miteinander verbindenden Verbindungssteg (19) weg weist.

5. Anordnung (10) nach einem der Ansprüche 2 bis 4, **dadurch gekennzeichnet, dass** die erste Wange (17) und die zweite Wange (18) des Trägerelements (12) und/oder die erste Wange (21) und die zweite Wange (22) des Halteelements (11) an einander gegenüberliegenden Seiten des jeweiligen die beiden Wangen (17, 18; 21, 22) miteinander verbindenden Verbindungsstegs (19, 23) angeordnet sind.

6. Anordnung (10) nach einem der Ansprüche 1 bis 5, **dadurch gekennzeichnet, dass** das zweite Pufferelement (15) mit dem Halteelement (11) mittels einer Schraube verbindbar oder verbunden ist.

7. Anordnung (10) nach einem der Ansprüche 1 bis 6, **dadurch gekennzeichnet, dass** das erste Pufferelement (14) und/oder das zweite Pufferelement (15) schwingungsdämpfend ausgebildet ist; und/oder
das erste Pufferelement (14) und/oder das zweite Pufferelement (15) buchsenförmig ausgebildet ist.

8. Anordnung (10) nach einem der Ansprüche 1 bis 7, **dadurch gekennzeichnet, dass** das Trägerelement (12) zwei erste Pufferelemente (14) und zwei zweite Pufferelemente (15) und das Halteelement (11) zwei Befestigungsstege (13) umfasst, wobei zum Befestigen des Trägerelements (12) an dem Halteelement (11) jeweils ein erstes Pufferelement (14) mit jeweils einem Befestigungssteg (13) und jeweils ein zweites Pufferelement (15) mittels jeweils eines Befestigungsmittels (16) mit dem Halteelement (11) verbindbar oder verbunden ist.

9. Anordnung (10) nach einem der Ansprüche 1 bis 8, **dadurch gekennzeichnet, dass** das Halteelement (11) form-, kraft- und/oder stoffschlüssig mit der Karosserie (3) der landwirtschaftlichen Arbeitsmaschine (1) verbindbar oder verbunden ist.

10. Anordnung (10) nach einem der Ansprüche 1 bis 9, **dadurch gekennzeichnet, dass** das Trägerelement (12) kraft-, form- und/oder stoffschlüssig mit dem Steuergerät (6) befestigbar oder befestigt ist.

11. Anordnung (10) nach einem der Ansprüche 1 bis 9, **dadurch gekennzeichnet, dass** das Trägerelement (12) integral mit dem Steuergerät (6) ausgebildet ist.

12. Anordnung (10) nach einem der Ansprüche 1 bis 11, **dadurch gekennzeichnet, dass** das Trägerelement (12) an einer der Befestigung des Steuergeräts (6) dienenden Seite abgewandten Seite Kühlrippen (25) umfasst.

13. Landwirtschaftliche Arbeitsmaschine (1), insbesondere Traktor (2), mit einem Steuergerät (6), **dadurch gekennzeichnet, dass** die landwirtschaftliche Arbeitsmaschine (1) eine Anordnung (10) zum Befestigen eines Steuergeräts (6) an einer Karosserie (3) der landwirtschaftlichen Arbeitsmaschine (1) nach einem der Ansprüche 1 bis 12 umfasst mittels der das Steuergerät (6) an der Karosserie (3) der landwirtschaftlichen Arbeitsmaschine (1) befestigt ist.

14. Landwirtschaftliche Arbeitsmaschine (1) nach Anspruch 13, **dadurch gekennzeichnet, dass** das Steuergerät (6) ein Motorsteuergerät ist, das mittels der Anordnung (10) an einem der Halterung einer Motorhaube (8) der landwirtschaftlichen Arbeitsmaschine (1) dienenden Karosserieelement (9) der landwirtschaftlichen Arbeitsmaschine (1) befestigt ist.

## Claims

1. Arrangement (10) for fastening a control unit (6) to a body (3) of an agricultural working machine (1), in particular a tractor (2), wherein the arrangement (10) comprises a retaining element (11), which is fastenable or fastened to the body (3) of the agricultural working machine (1), and a carrier element (12), on which the control unit (6) can be arranged or is arranged, wherein the retaining element (11) comprises at least one fastening web (13), wherein the carrier element (12) comprises at least one first buffer element (14) and at least one second buffer element (15), wherein the first buffer element (14) and the second buffer element (15) are arranged on two different sides of the carrier element (12), wherein, to fasten the carrier element (12) to the retaining element (11), the first buffer element (14) is connectable or connected to the retaining element (11) by the fastening web (13) and the second buffer element (15) is connectable or connected thereto by means of a fastening means (16), **characterized in that** the retaining element (11) is U-shaped, the retaining element (11) comprising a first cheek (21) and a second cheek (22), which are connected to each other by means of a connecting web (23), preferably two connecting webs (23), wherein the fastening web (13) is formed on the first cheek (21), wherein the second cheek (22) comprises at least one recess (24), in particular bore, for receiving the fastening means (16), wherein the fastening web (13) is a bolt with a conically formed bolt head, wherein the first buffer element (14) is latchingly connectable or connected to the fastening web (13).

2. Arrangement (10) according to Claim 1, **characterized in that** the carrier element (12) is U-shaped, wherein the carrier element (12) comprises a first cheek (17) and a second cheek (18), which are connected to each other by means of a connecting web (19), wherein the first buffer element (14) is arranged on the first cheek (17) and the second buffer element (15) on the second cheek (18).

3. Arrangement (10) according to Claim 2, **characterized in that** the first cheek (17) comprises at least one recess, in particular bore, in which the first buffer element (14) is arranged, and the second cheek (18) comprises at least one recess, in particular bore, in which the second buffer element (15) is arranged.

4. Arrangement (10) according to Claim 3, **characterized in that** the first buffer element (14) and the second buffer element (15) are arranged in each case in the respective recess of the first cheek (17) and the second cheek (18) in such a way that a recess (20) formed in the first buffer element (14) and in the second buffer element (15) for receiving the fastening web (13) or the fastening means (16) faces away from the connecting web (19) connecting the first cheek (17) and the second cheek (18) to each other.

5. Arrangement (10) according to any one of Claims 2 to 4, **characterized in that** the first cheek (17) and the second cheek (18) of the carrier element (12) and/or the first cheek (21) and the second cheek (22) of the retaining element (11) are arranged on mutually opposite sides of the respective connecting web (19, 23) connecting the two cheeks (17, 18; 21, 22) to each other.

6. Arrangement (10) according to any one of Claims 1 to 5, **characterized in that** the second buffer element (15) is connectable or connected to the retaining element (11) by means of a screw.

7. Arrangement (10) according to any one of Claims 1 to 6, **characterized in that** the first buffer element (14) and/or the second buffer element (15) is/are designed to damp vibrations; and/or
the first buffer element (14) and/or the second buffer element (15) is/are in the form of a bushing.

8. Arrangement (10) according to any one of Claims 1 to 7, **characterized in that** the carrier element (12) comprises two first buffer elements (14) and two second buffer elements (15) and the retaining element (11) comprises two fastening webs (13), wherein, to fasten the carrier element (12) to the retaining element (11), a first buffer element (14) is in each case connectable or connected to the retaining element (11) by a respective fastening web (13) and a second buffer element (15) is in each case connectable or connected thereto by means of a respective fastening means (16).

9. Arrangement (10) according to any one of Claims 1 to 8, **characterized in that** the retaining element (11) is connectable or connected to the body (3) of the agricultural working machine (1) in a form-fitting, force-fitting and/or material-bonded manner.

10. Arrangement (10) according to any one of Claims 1 to 9, **characterized in that** the carrier element (12) is fastenable or fastened to the control unit (6) in a form-fitting, force-fitting and/or material-bonded manner.

11. Arrangement (10) according to any one of Claims 1 to 9, **characterized in that** the carrier element (12) is formed integrally with the control unit (6).

12. Arrangement (10) according to any one of Claims 1 to 11, **characterized in that** the carrier element (12) comprises cooling fins (25) on a side facing away from the side intended for fastening of the control unit (6).

13. Agricultural working machine (1), in particular tractor (2), with a control unit (6), **characterized in that** the agricultural working machine (1) comprises an arrangement (10) for fastening a control unit (6) to a body (3) of the agricultural working machine (1) according to any one of Claims 1 to 12, by means of which the control unit (6) is fastened to the body (3) of the agricultural working machine (1).

14. Agricultural working machine (1) according to Claim 13, **characterized in that** the control unit (6) is a motor control unit which is fastened by means of the arrangement (10) to a body element (9) of the agricultural working machine (1) serving for the mounting of a bonnet (8) of the agricultural working machine (1).

## Revendications

1. Agencement (10) de fixation d'un appareil de commande (6) sur une carrosserie (3) d'une machine de travail agricole (1), en particulier d'un tracteur (2), l'agencement (10) comprenant un élément de retenue (11) pouvant être fixé ou étant fixé à la carrosserie (3) de la machine de travail agricole (1), et un élément de support (12) sur lequel l'appareil de commande (6) peut être disposé ou est disposé, l'élément de retenue (11) comprenant au moins une nervure de fixation (13), l'élément de support (12) comprenant au moins un premier élément tampon (14) et au moins un second élément tampon (15), le premier élément tampon (14) et le second élément tampon (15) étant disposés sur deux côtés différents de l'élément de support (12), dans lequel, pour la fixation de l'élément de support (12) à l'élément de retenue (11), le premier élément tampon (14) peut être relié ou est relié à la nervure de fixation (13) et le second élément tampon (15) peut être relié ou est relié à l'élément de retenue (11) au moyen d'un moyen de fixation (16), **caractérisé en ce que** l'élément de retenue (11) est réalisé en forme de U, l'élément de retenue (11) comprenant une première joue (21) et une seconde joue (22) qui sont reliées l'une à l'autre par une nervure de liaison (23), de préférence deux nervures de liaison (23), la nervure de fixation (13) étant réalisée sur la première joue (21), la seconde joue (22) comprenant au moins un évidement (24), en particulier un alésage, pour recevoir le moyen de fixation (16), la nervure de fixation (13) étant un boulon ayant une tête de boulon conique, le premier élément tampon (14) pouvant être relié ou étant relié par encliquetage à la nervure de fixation (13).

2. Agencement (10) selon la revendication 1, **caractérisé en ce que** l'élément de support (12) est réalisé en forme de U, l'élément de support (12) comprenant une première joue (17) et une seconde joue (18), qui sont reliées l'une à l'autre au moyen d'une nervure de liaison (19), le premier élément tampon (14) étant disposé sur la première joue (17) et le second élément tampon (15) étant disposé sur la seconde joue (18).

3. Agencement (10) selon la revendication 2, **caractérisé en ce que** la première joue (17) comprend au moins un évidement, en particulier un alésage, dans lequel est disposé le premier élément tampon (14), et la seconde joue (18) comprend au moins un évidement, en particulier un alésage, dans lequel est disposé le second élément tampon (15).

4. Agencement (10) selon la revendication 3, **caractérisé en ce que** le premier élément tampon (14) et le second élément tampon (15) sont respectivement disposés dans l'évidement respectif de la première joue (17) et de la seconde joue (18) de telle manière qu'un évidement (20) réalisé dans le premier élément tampon (14) et un évidement réalisé dans le second élément tampon (15) pour recevoir la nervure de fixation (13) ou le moyen de fixation (16) sont orientés à l'opposé de la nervure de liaison (19) reliant la première joue (17) et la seconde joue (18) l'une à l'autre.

5. Agencement (10) selon l'une quelconque des revendications 2 à 4, **caractérisé en ce que** la première joue (17) et la seconde joue (18) de l'élément de support (12) et/ou la première joue (21) et la seconde joue (22) de l'élément de retenue (11) sont disposées sur des côtés opposés de la nervure de liaison (19, 23) respective reliant les deux joues (17, 18 ; 21, 22) l'une à l'autre.

6. Agencement (10) selon l'une quelconque des revendications 1 à 5, **caractérisé en ce que** le second élément tampon (15) peut être relié ou est relié à l'élément de retenue (11) au moyen d'une vis.

7. Agencement (10) selon l'une quelconque des revendications 1 à 6, **caractérisé en ce que** le premier élément tampon (14) et/ou le second élément tampon (15) sont réalisés de manière à amortir les vibrations ; et/ou le premier élément tampon (14) et/ou le second élément tampon (15) sont réalisés en forme de douille.

8. Agencement (10) selon l'une quelconque des revendications 1 à 7, **caractérisé en ce que** l'élément de support (12) comprend deux premiers éléments tampons (14) et deux seconds éléments tampons (15) et l'élément de retenue (11) comprend deux nervures de fixation (13), dans lequel, pour la fixation de l'élément de support (12) à l'élément de retenue (11), respectivement un premier élément tampon (14) peut être relié ou est relié respectivement à une nervure de fixation (13) et respectivement un second élément tampon (15) peut être relié ou est relié au moyen respectivement d'un moyen de fixation (16) à l'élément de retenue (11).

9. Agencement (10) selon l'une quelconque des revendications 1 à 8, **caractérisé en ce que** l'élément de retenue (11) peut être relié ou est relié à la carrosserie (3) de la machine de travail agricole (1) par complémentarité de forme, de force et/ou de matériau.

10. Agencement (10) selon l'une quelconque des revendications 1 à 9, **caractérisé en ce que** l'élément de support (12) peut être fixé ou fixé sur l'appareil de commande (6) par complémentarité de force, de forme et/ou de matériau.

11. Agencement (10) selon l'une quelconque des revendications 1 à 9, **caractérisé en ce que** l'élément de support (12) est réalisé d'une seule pièce avec l'appareil de commande (6).

12. Agencement (10) selon l'une quelconque des revendications 1 à 11, **caractérisé en ce que** l'élément de support (12) comprend des nervures de refroidissement (25) sur un côté opposé à un côté servant à la fixation de l'appareil de commande (6).

13. Machine de travail agricole (1), en particulier tracteur (2), comportant un appareil de commande (6), **caractérisée en ce que** la machine de travail agricole (1) comprend un agencement (10) pour fixer un appareil de commande (6) à une carrosserie (3) de la machine de travail agricole (1) selon l'une quelconque des revendications 1 à 12, au moyen duquel l'agencement de commande (6) est fixé à la carrosserie (3) de la machine de travail agricole (1).

14. Machine de travail agricole (1) selon la revendication 13, **caractérisée en ce que** l'appareil de commande (6) est un appareil de commande de moteur qui est fixé au moyen de l'agencement (10) à un élément de carrosserie (9) de la machine de travail agricole (1) qui sert à maintenir un capot de moteur (8) de la machine de travail agricole (1).
